(19) Europäisches Patentamt
European Patent Office
Office européen des brevets

(11) **EP 4 636 610 A1**

(12) **EUROPEAN PATENT APPLICATION**

(43) Date of publication:
**22.10.2025 Bulletin 2025/43**

(21) Application number: **24305601.7**

(22) Date of filing: **15.04.2024**

(51) International Patent Classification (IPC):
**G06F 16/901** (2019.01)    **G06F 17/10** (2006.01)

(52) Cooperative Patent Classification (CPC):
**G06F 16/9024; G06F 17/10**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Dassault Systèmes**
**78140 Vélizy-Villacoublay (FR)**

(72) Inventors:
- **Clarou, Pierre**
  **78140 Vélizy-Villacoublay (FR)**
- **Mezghanni, Mariem**
  **78140 Vélizy-Villacoublay (FR)**

(74) Representative: **Bandpay & Greuter**
**11 rue Christophe Colomb**
**75008 Paris (FR)**

(54) **LOCAL TOPOLOGICAL SIMILARITY RETRIEVAL IN A B-REP MODEL**

(57) The disclosure relates to a computer-implemented method for local topological similarity retrieval in a B-rep model. The B-rep model is represented by a given B-rep graph. Each node of the given B-rep graph represents a B-rep element and is associated with a topological signature of the element. The method comprises providing a query B-rep graph. Each node of the query B-rep graph represents a B-rep element and is associated with a topological signature of the element. The method further comprises determining one or more sub-graphs of the given B-rep graph. Each determined sub-graph is isomorphic to the query B-rep graph. The determining of the one or more sub-graphs comprises searching for sub-graphs isomorphic to the query B-rep graph. The determining of the one or more sub-graphs further comprises filtering the sub-graphs isomorphic to the query B-rep graph. The filtering is based on topological signature proximity with the query B-rep graph.

Inputs

Full 3D model          Query

FIG. 1

EP 4 636 610 A1

**Description**

**TECHNICAL FIELD**

The disclosure relates to the field of computer programs and systems, and more specifically to a method, system and program for local topological similarity retrieval in a B-rep model.

**BACKGROUND**

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

Within this context, there is a need for improved solutions for local topological similarity retrieval in a B-rep model.

**SUMMARY**

It is therefore provided a computer-implemented method for local topological similarity retrieval in a B-rep model. The B-rep model is represented by a given B-rep graph. Each node of the given B-rep graph represents a B-rep element and is associated with a topological signature of the element. The method comprises providing a query B-rep graph. Each node of the query B-rep graph represents a B-rep element and is associated with a topological signature of the element. The method further comprises determining one or more sub-graphs of the given B-rep graph. Each determined sub-graph is isomorphic to the query B-rep graph. The determining of the one or more sub-graphs comprises searching for sub-graphs isomorphic to the query B-rep graph. The determining of the one or more sub-graphs further comprises filtering the sub-graphs isomorphic to the query B-rep graph. The filtering is based on topological signature proximity with the query B-rep graph.

The method may comprise one or more of the following:

- the determining of the one or more sub-graphs comprises iterations of:

  ∘ given a sub-graph of the query B-rep graph, the sub-graph resulting from the previous iteration, adding a node of the query B-rep graph to the sub-graph; and
  ∘ determining all sub-graphs of the given B-rep graph already determined as isomorphic and similar according to topological signature proximity to the sub-graph of the query B-rep graph resulting from the previous iteration and remaining isomorphic to the sub-graph of the query B-rep graph when adding a node corresponding to the node added to the sub-graph of the query B-rep graph, and such that the determined sub-graphs remain similar to the sub-graph of the query graph according to topological signature proximity when adding the node;

- the determining of said all sub-graphs comprises, for sub-graphs determined as remaining isomorphic to the sub-graph of the query B-rep graph when adding the node, selecting the sub-graphs for which the added node and the corresponding node added to the query have topological signature proximity;
- two nodes have topological signature proximity when a similarity score between their two topological signatures is larger than a predefined threshold;
- the topological signatures are vectors, and the similarity score is a similarity score between vectors;
- the similarity score is a cosine similarity or any other distance between vectors;
- the method further comprises, for each sub-graph of the one or more sub-graphs resulting from the determining:

○ computing a graph similarity score quantifying a similarity between the sub-graph and the query B-rep graph based on the topological signatures of their elements;

- the method further comprises:

○ ranking the one or more sub-graphs according to their computed graph similarity score;
○ clustering the one or more sub-graphs according to their computed graph similarity score;
○ discarding one or more sub-graphs for which the graph similarity score is smaller than a predefined threshold; and/or
○ selecting one or more sub-graphs for which the graph similarity score is larger than a predefined threshold; and/or

- the graph similarity score between two B-rep graphs is:

○ a mean of the vector similarities each between the topological signatures of two corresponding nodes in the two graphs; or
○ a minimal vector similarity among the vector similarities each between the topological signatures of two corresponding nodes in the two graphs

It is further provided a computer program comprising instructions for performing the method.
It is further provided a computer readable storage medium having recorded thereon the computer program.
It is further provided a computer system comprising a processor coupled to a memory, the memory having recorded thereon the computer program.

## BRIEF DESCRIPTION OF THE DRAWINGS

Non-limiting examples will now be described in reference to the accompanying drawings, where:

- FIG.s 1 to 10 illustrate the method; and

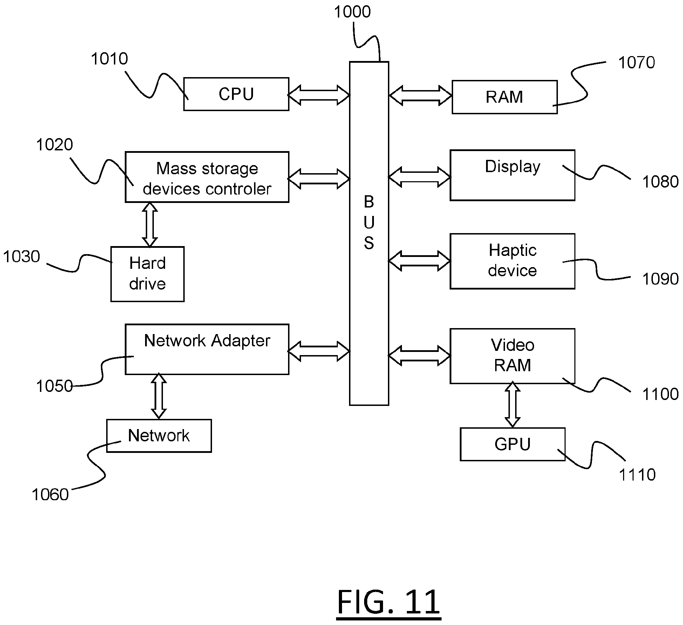

- FIG. 11 shows an example of the system.

## DETAILED DESCRIPTION

It is proposed a computer-implemented method for local topological similarity retrieval in a B-rep model. The B-rep model is represented by a given B-rep graph. Each node of the given B-rep graph represents a B-rep element and is associated with a topological signature of the element. The method comprises providing a query B-rep graph. Each node of the query B-rep graph represents a B-rep element and is associated with a topological signature of the element. The method further comprises determining one or more sub-graphs of the given B-rep graph. Each determined sub-graph is isomorphic to the query B-rep graph. The determining of the one or more sub-graphs comprises searching for sub-graphs isomorphic to the query B-rep graph. The determining of the one or more sub-graphs further comprises filtering the sub-graphs isomorphic to the query B-rep graph. The filtering is based on topological signature proximity with the query B-rep graph.
The method constitutes an improved solution for local topological similarity retrieval in a B-rep model.
Indeed, the query B-rep graph is a B-rep graph of a B-rep (which can be referred to as "the query B-rep"), and thus represents a set of B-rep elements, or, in other words, a set of connected B-rep faces separated by B-rep edges, which forms a mechanical part, or a local portion thereof, such as a given mechanical feature. The method searches for sub-graphs of the B-rep graph which are isomorphic to this query B-rep graph. This means that the method finds sub-graphs representing B-rep portions (specifically, portions of the B-rep represented by the given B-rep graph, which represents parts of the mechanical part represented by the B-rep) having a same organization of faces and edges than that of the query B-rep graph. These sub-graphs thus already have topological similarity with the query B-rep graph. But the method further filters these sub-graphs based on topological signature proximity. Each B-rep element, be it one of the query B-rep graph or of the given B-rep graph, is indeed associated with a topological signature (*e.g.* a vector), that describes its topology and geometry. Filtering based on topological signature proximity thus means that sub-graphs found isomorphic with the query B-rep graph are filtered based on a proximity of their topological signatures with those of the query B-rep graphs. The filtering may be based on the topological signatures of the elements taken one by one, *i.e.* the filtering is based on an element-by-element comparison between the topological signatures of the elements of the sub-graphs and the topological signatures of corresponding elements in the query B-rep graphs. The filtering may be alternatively based on the comparison of an overall score or mean of the topological signatures between the sub-graphs and the query B-rep graph.

In any case, this comparison and filtering allow to filter out (discard) those sub-graphs isomorphic to the query B-rep graph but for which topological similarity is not sufficient due to a lack of topological signature proximity. This allows to determine the sub-graphs of the given B-rep graph with sufficient topological similarity with the query B-rep graph, and thus to find, in the given B-rep, portions representing parts of the mechanical part represented by the given B-rep topologically similar to the part represented by the input query B-rep graph. Furthermore, the level of topological signature proximity in the filtering can be controlled (automatically or by a user), for example through the usage of topological signature proximity threshold(s), to accept more or less sub-graphs in the filtering.

The query B-rep graph may be a sub-graph of the given B-rep graph and may thus represent a sub-part of the mechanical part represented by the given B-rep graph and may be provided as input to the method upon the user graphically selecting the corresponding portion of the given B-rep, the given B-rep being displayed. Thus, the method allows a user to graphically select a B-rep portion and returns to the user other portions of the B-rep which are topologically similar to the selected portion. These other portions and the selected portions represent same or topologically similar parts of the mechanical part represented by the B-rep. These portions may for example by same or topologically similar cylinders in a B-rep representing a wheel (such example is discussed hereinafter). The method thus allows a user to select graphically one portion of the B-rep and then automatically provides to the user topologically similar or identical portions. This saves user-interactions for the task of selecting these portions, since only one portion needs to be selected by the user, which corresponds to the user performing a click/touch or a few clicks/touches on the portion, or for example in its faces, the other portions being automatically retrieved and selected by the computer system. The method thus improves ergonomics for selection of similar portions in a (*e.g.* displayed) B-rep model. The method also offers interactivity as the user may control the similarity thresholds used for evaluation of local topological similarity (as discussed hereinafter). The method is furthermore CPU-efficient as its builds upon a neighbor-aware topological signature which allows to considerably alleviate the problem by conducting pairwise node comparison between query and search graphs and simplifying the latter by removing nodes that cannot be candidates (non-similar to any of the query nodes). The system is thus responsive and offers fast (e.g. immediate) feedback to the user. Moreover, the method may return the determined sub-graphs along with the bijections between them and the query, which allows interpretability of the solutions.

The method may be included in a design and/or manufacturing process of a mechanical part represented by the given B-rep. Such a process may comprise:

- Providing the given B-rep, for example as a result of an initial design process;
- By the user, graphically selecting a portion of the displayed given B-rep, the portion being represented by the input query B-rep graph;
- Performing the method, thereby automatically retrieving the portions of the B-rep topologically similar or identical to the selected portions (for example, all the cylinders of same/similar size, positioning, neighborhood and diameter in a B-rep representing a wheel);
- Optionally, displaying all the portions (retrieved and selected) to the user, for example by displaying the B-rep model and graphically highlighting the retrieved portions;
- By the user, defining a design operation to be applied to all the portions. For example, in the case of the wheel, defining a new diameter for the cylinders, which represent screws or bolts locations, to enable the use of bigger screws/bolds for improved robustness;
- By the system, automatically applying the design operation to all the portions in a uniform way (*e.g.* setting automatically the diameters of all the cylinders with the defined new diameter);
- Optionally, using the modified B-rep to manufacture the part represented by this B-rep, which may comprise:

  ○ Converting the B-rep or its B-rep graph or its corresponding feature tree into manufacturing instructions to set and/or control the manufacturing process, for example by converting the B-rep into a CAM (Computer-Aided Manufacturing) file; and/or
  ○ Storing the manufacturing instructions (*e.g.* as a CAM file) and/or transmitting them to the manufacturing factory and/or to the appropriate manufacturing machine; and/or
  ○ Manufacturing the mechanical part (*e.g.* based on the manufacturing instructions).

The method is for local topological similarity retrieval in a B-rep model. This means that the method, given an input B-rep, identifies one or more B-rep portions of another B-rep and which are topologically similar to the input B-rep. Specifically, the input B-rep, also referred to as the query B-rep, is the B-rep represented by the query B-rep graph, and the identified B-rep portion(s) are portions of the B-rep represented by the given B-rep graph which are represented by the determined sub-graph(s).

"B-rep", also referred to as "B-Rep", stands for "Boundary Representation". B-rep is, in CAD applications, the most common type of modeling. B-rep is a mathematically precise representation of a 3D object. This representation defines a solid as a collection of connected surface elements, which define the boundary between interior and exterior points. There are two types of information in a B-rep: topological components and geometric definitions for those components. Topological components comprise vertices, edges and faces defining 3D object surface, and the connections between them. In addition to connectivity, topological information also includes orientation of edges and face, while geometric information consists usually of mathematical equations describing vertices, edges and faces (points, curves and surfaces respectively).

Any B-rep (i.e. boundary representation) herein is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

Besides vertices, faces and edges, each B-rep herein also comprises co-edges. A co-edge is an oriented edge, *i.e.* an edge of the B-rep with additional orientation information. The co-edges thereby define an ordering around the B-rep faces and the faces adjacency, *i.e.* they define the topology of the B-rep. The co-edges link the B-rep entities altogether. Each co-edge has one parent face (*i.e.* the face for which it defines a bound), one parent edge, (*i.e.* by definition a co-edge is an oriented edge and thus has a parent edge), one mate co-edge which is the co-edge having the same parent edge, one next co-edge, corresponding to the next co-edge in the loop where the co-edge belongs, and one previous co-edge, corresponding to the previous co-edge in the loop where the co-edge belongs. Each co-edge maintains an adjacency relationship with the next and previous co-edge around its parent face, the mating co-edge on the adjacent face, the parent face and the parent edge.

Any B-rep herein is represented by a B-rep graph. A B-rep graph herein is a graph representation of a respective B-rep and comprises graph nodes and graph edges. Each graph node represents a respective edge, a respective face or a respective co-edge of the respective B-rep. This means that for each edge of the B-rep, there is a respective graph node, for each face of the B-rep, there is a respective graph node, and for each co-edge of the B-rep, there is a respective graph node. Each graph node further comprises a topological signature associated with (*i.e.* attached to) the graph node. The topological signature of a B-rep element may be any data, for example a vector, capturing the topology of the B-rep element. The signature may also capture the geometry of the B-rep element, and/or data about its neighborhood (*i.e.* neighboring elements). Thus, the topological signature captures the local topology corresponding to the B-rep element and may also be referred to as "local topological signature" (of the element). The local topological signature may be the local topological signature outputted by the local Deep CAD neural network learnt according to claim 1 of European Patent Application EP23306709.9 filed by DASSAULT SYSTEMES, or according to any claim depending on claim 1 of European Patent Application EP23306709.9 or any example or implementation of the learning method disclosed in European Patent Application EP23306709.9. The content of European Patent Application EP23306709.9 as filed is incorporated herein by reference. For any B-rep graph herein, such as the query B-rep graph or the given B-rep graph, the method may optionally comprise an initial step of applying this local Deep CAD neural network learnt according to the learning method of European Patent Application EP23306709.9 to each node of the B-rep graph, thereby outputting for each node a local topological signature which forms the topological signature associated with the node.

The B-rep graph also comprises graph edges. Each respective graph edge connects two respective graph nodes, a respective first node and a respective second node. The first graph node represents a respective co-edge. The second graph node represents one of:

- a face associated with the respective co-edge (*i.e.* the parent face of the co-edge, that is the face for which it defines a bound),
- an edge (*i.e.* the parent edge of the co-edge),
- an adjacent co-edge (*i.e.* the next or previous co-edge, that is the next or previous co-edge in the loop where the co-edge belongs), or
- a mating co-edge (*i.e.* the co-edge having the same parent edge).

The given B-rep graph is an input of the method. It represents a given B-rep model that represents a mechanical part. Each node of the given B-rep graph represents an element of this B-rep and is associated with the topological signature of the element. The method may comprise an initial step of providing the given B-rep and/or its B-rep graph, for example by retrieval (*e.g.* download) from a (*e.g.* distant) memory, server, database, or cloud, or by designing the B-rep and its B-rep graph.

The method comprises providing the query B-rep graph. The query B-rep graph may be a sub-graph of the given B-rep graph, and may thus represent a portion of the given B-rep. The query B-rep graph may alternatively be a B-rep graph of another B-rep or of a portion of another B-rep. As for any B-rep graph herein, each node of the query B-rep graph represents a B-rep element and is associated with the topological signature of the element.

Providing the query B-rep graph may be performed as follows. First, the method comprises displaying a B-rep, which is the given B-rep or another B-rep. Then, a user selects a set of B-rep elements in the displayed B-rep, for example a set of faces. This may be done by graphical user interaction. For example, the user may select the graphical elements one by one by clicking on or performing a touch on each element. Then, the computer system carrying out the method may automatically infer the B-rep graph corresponding to the user-selection, by extracting it from the B-rep graph of the displayed B-rep. The computer may for example infer as the query graph the sub-graph comprising the nodes of all the faces selected by the user and of all the other B-rep elements (*e.g.* edges) belonging to at least one of these faces.

Further to the providing of the query B-rep graph, the method further comprises determining one or more sub-graphs of the given B-rep graph. Each determined sub-graph is isomorphic to the query B-rep graph. In the present disclosure, two graphs are isomorphic if there exists a bijection between their nodes and if the bijection satisfies the following: for any couple of nodes of the first graph connected by an edge, the images of the two nodes (by the bijection) in the second graph are also connected by an edge, and conversely. A first node in the first graph is said to correspond to the second node in the second graph if it is the image of the second node by such bijection.

The determining of the one or more sub-graphs comprises searching for sub-graphs (*i.e.* of the given B-rep graph) isomorphic to the query B-rep graph. This may be done by any suitable method, for example by using a breadth first search. The determining also comprises filtering the sub-graphs isomorphic to the query B-rep graph. The filtering is based on topological signature proximity with the query B-rep graph. Filtering sub-graphs means discarding/filtering out at least some of the sub-graphs found isomorphic to the query B-rep. In specific, these sub-graphs are discarded based on topological signature proximity with the query B-rep graph, *i.e.* either because one or more of nodes and corresponding node(s) in the query B-rep graph each have discrepant/not sufficiently similar topological signatures, or because the signatures of the nodes of the sub-graph altogether and the signatures of the nodes of the query graph altogether have a too significant discrepancy/and insufficient similarity.

The determining of the one or more sub-graphs of the given B-rep graph may comprise iterations.

Each iteration comprises, given a sub-graph of the query B-rep graph, the sub-graph resulting from the previous iteration, adding a node of the query B-rep graph to the sub-graph. At the first iteration, the sub-graph resulting from the previous iteration is an initial sub-graph (*i.e.* it does not per se result from a previous iteration but from an initialization). This initial sub-graph may be the empty set, in which case adding a node of the query B-rep graph may consist in adding any node (*e.g.* randomly) of the query B-rep graph to the empty set, this single node forming the sub-graph of the B-rep query graph that results from the first iteration. At each iteration as of the second one, the sub-graph of the query B-rep graph that results from the previous iteration comprises at least one node, and adding a node of the query B-rep graph may consist in adding any node (*e.g.* randomly) of the query B-rep graph that is not already comprised in the sub-graph resulting from the previous iteration.

Each iteration comprises then determining all sub-graphs of the given B-rep graph already determined as isomorphic and similar according to topological signature proximity to the sub-graph of the query B-rep graph resulting from the previous iteration and remaining isomorphic to the sub-graph of the query B-rep graph when adding a node corresponding to the node added to the sub-graph of the query B-rep graph, and such that the determined sub-graphs remain similar to the sub-graph of the query graph according to topological signature proximity when adding the node. In other words, at each iteration as of the second one, there are sub-graphs of the given B-rep graph which result from the previous iteration and which are: 1) isomorphic to the sub-graph of the query B-rep graph resulting from the previous iteration, and 2) similar to this sub-graph according to topological signature proximity. The determining consists in determining, amongst these sub-graphs, each one which, when adding to it a node that corresponds to the node added to the query graph: 1) remains isomorphic to the sub-graph of the query B-rep graph resulting from the previous iteration and to which the node has been added, and 2) remains similar to this sub-graph according to topological signature proximity. This may consist in, for each sub-graph which were isomorphic and topologically similar to the sub-graph of the query at the previous iteration, determining whether there exists a node (or several) of the given B-rep graph to add to the sub-graph so that isomorphy and topological signature proximity are maintained with the sub-graph of the query graph resulting from the previous iteration.

The determining of said all sub-graphs may comprise, for sub-graphs determined as remaining isomorphic to the sub-graph of the query B-rep graph when adding the node, selecting the sub-graphs for which the added node and the corresponding node added to the query have topological signature proximity. The topological proximity between two nodes may be defined as follows: two nodes have topological signature proximity when a similarity score between their two topological signatures is larger than a predefined threshold. This predefined threshold may be larger than or equal to 0.5, for example larger than or equal to 0.6, for example larger than or equal to 0.7, for example larger than or equal to 0.8, for example larger than or equal to 0.8, for example equal to 1, 0 signifying minimal similarity, and 1 maximal similarity. The threshold may be set and non-modifiable. Alternatively, the threshold may be modifiable and for example set by a user (*e.g.* at an initial stage of the method). The topological signatures may, as previously discussed, be vectors, and the similarity score may in this case be a similarity score between vectors, for example a cosine similarity.

The method may further comprise, for each sub-graph of the one or more sub-graphs resulting from the determining (*i.e.* the determining of the sub-graphs of the given B-rep graph isomorphic and topologically similar to the query), computing a graph similarity score. The graph similarity score quantifies a similarity (*i.e.* topological similarity) between the sub-graph and the query B-rep graph based on the topological signatures of their elements. The graph similarity score between two B-rep graphs may be a mean (*e.g.* L1 mean, L2 mean, geometrical mean) of the vector similarities (*e.g.* cosine similarities) each between the topological signatures of the corresponding nodes in the two graphs. Alternatively, graph similarity score between two B-rep graphs may be a minimal vector similarity among the vector similarities each between the topological signatures of the corresponding nodes in the two graphs.

The method may further comprise one or more of the following:

- ranking the one or more sub-graphs according to their computed graph similarity score, e.g. in a decreasing order of the score;
- clustering the one or more sub-graphs according to their computed graph similarity score;
- discarding one or more sub-graphs for which the graph similarity score is smaller than a predefined threshold (*e.g.* which may be set at an initial stage of the method); and/or
- selecting one or more sub-graphs for which the graph similarity score is larger than a predefined threshold (*e.g.* which may be set at an initial stage of the method).

Implementations of the method are now discussed.

The inputs of the method are, in these implementations:

- The given Face-B-rep graph (*i.e.* a B-rep graph for which all the nodes represent faces) of a 3D CAD object (B-rep), where each node of the graph has a topological signature, such that two nodes have similar signatures if and only if the two associated faces are topologically similar, and
- The Query, which is a subgraph of the given B-rep graph (or of another B-rep graph). The faces of the query also have their topological signatures.

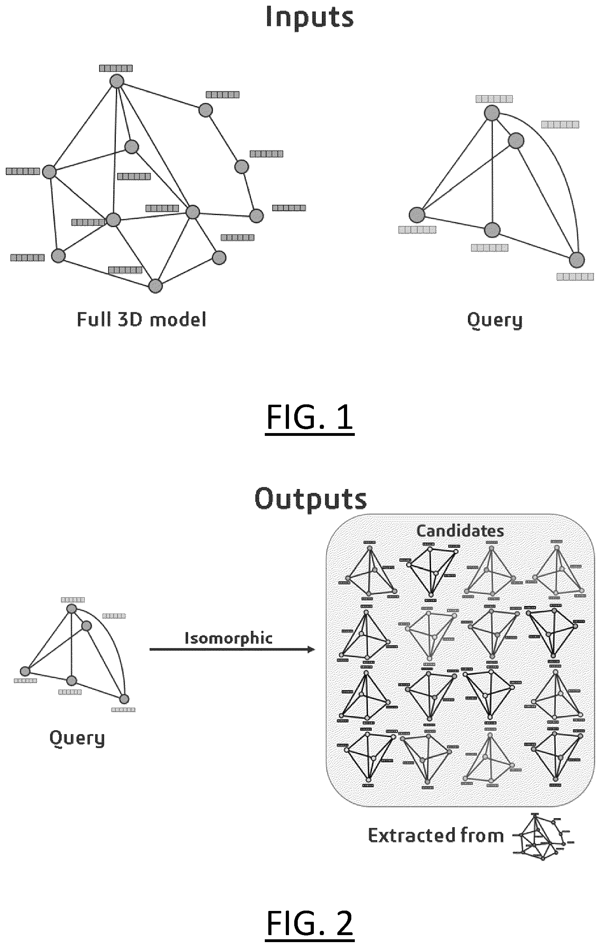

FIG. 1 illustrates the inputs, in the case where the query graph (caption "query" in the Figure) is a sub-graph of the given B-rep graph (illustrated by the caption "Full 3D model").

The purpose is to detect a list of graphs, which are isomorph to the query. FIG. 2 illustrate these outputs (detected isomorphic graphs).

It is to be noted that these implementations only use the Faces of the B-rep objects, i.e. focus on face B-rep graphs. However, everything works the same way if Faces and edges features or even more feature types like loops are considered.

**Definitions**

*Let G the graph of the CAD model,*

- *V(G) is the list of the nodes from G*
- *E(G) is the list of the edges from G*

- *For all of the demonstration, $V(G)^n = \{p \in \mathcal{P}\ (V(G)), |p| = n\}$ where $\mathcal{P}$ is the the power set operator*
- *For $f, g \in V(G)^2$, $e(f, g)$ is the edge between f and g*
- *G and H are isomorphic $(G \cong H) \Leftrightarrow \exists\, \varphi: V(G) \mapsto V(H)$ bijective such that $\forall\, (f,g) \in G$, $e(f,g) \in E(G) \Leftrightarrow e(\varphi(f), \varphi(g)) \in E(H)$*
- *G' is a subgraph of G, if and only if*

  - $\exists n \in \mathbb{N}$, $\exists q \in V(G)^n | q = V(G')$. *We note $G' = G[q]$*
  - $\forall (f_1, f_2) \in G^2$, $e(f_1, f_2) \in E(G) \Leftrightarrow e(f_1, f_2) \in E(G')$

  *(The usual definition of subgraph is the following : $(f_1, f_2) \in G^2$, $e(f_1, f_2) \in G \Rightarrow e(f_1, f_2) \in G'$. But it is not useful for this project.)*
- *The number of nodes of a graph is refered to as his length*

*Let $q = (f_1, f_2, \dots, f_n) \in V(G)^n$ the list of the faces from the query in G. G[q] is the graph of the query.*

**Candidate graph:**

*Let G[q'] where $= (f'_1, f'_2, \dots) \subset$*

*$V(G)^n$ a G subgraph. $(G[q'], \varphi: V(G[q']) \mapsto V(G[q]))$ is a candidate graph of q if:*

- *G[q'] and G[q] are isomorphic*
- *$\varphi$ is a bijection*

  $$\forall (f'_1, f'_2) \in q'^2, e(f'_1, f'_2) \in E(G[q']) \Leftrightarrow e(\varphi(f'_1), \varphi(f'_2)) \in E(G[q])$$

Remark: it can exist several isomorphisms for the same subgraph G[q']. There are then different candidates *(G[q'], $\varphi_1$) $\neq$ (G[q'], $\varphi_2$) $\Leftrightarrow$ $\varphi_1 \neq \varphi_2$.*

**Semicandidate graph:**

*Let G[q'] where $q' = (f'_1, f'_2, \dots) \in$*

*$V(G)^m$ a G subgraph. $(G[q'], \varphi: V(G[q']) \mapsto Im(\varphi))$ is a semicandidate graph of q if :*

- *G[q'] is isomorphic to a subgraph of G[q] named H*
- *$\varphi: V(G[q']) \mapsto V(H) = Im(\varphi)$ is a bijection*

  $$\forall (f'_1, f'_2) \in q'^2, e(f'_1, f'_2) \in E(G[q']) \Leftrightarrow e\big(\varphi(f'_1), \varphi(f'_2)\big) \in E(H)$$

Remark: *$\varphi': V(G[q']) \mapsto V(G[q])$, $\varphi = \varphi'$ is an injection*

**Theorem 1:**

*Let G[q'] where q' = (f'$_1$, f'$_2$, ...) ∈ V(G)$^m$ a G subgraph and*
*φ:V(G[q']) ↦ Im(φ) ⊂*
*V(G[q]), such that (G[q'], φ) is a semicandidate graph of q.*
*If m = n, then (G[q'], φ) is a candidate graph of q*

**Proof:**

*Let H ⊆ G[q] isomorphic to G[q'] with φ: V(G[q'])*
*↦ V(H) associated isomorphism*

- *n = m*
- *φ is an injection in G[q]*
  *⇒ |q'| = |q| = |V(H)| and V(H) ⊂ q*
  *⇒ So, V(H) = q and H = G[q]*

  *⇒ So, Im(φ) = V(H) = q = V(G[q])*
  *⇒ φ: V(G[q']) ↦ V(G[q]) is a bijection, because φ is an injection*

$$\Rightarrow \quad \forall (f_1', f_2') \in q'^2, e(f_1', f_2') \in E(G[q']) \Leftrightarrow e\big(\varphi(f_1'), \varphi(f_2')\big) \in E(H) = V(G[q])$$

*Finally (G[q'], φ) is a candidate graph of q*

**Remarks:**

- A candidate is obviously a semicandidate,
- A semicandidate of length *i ≠ n* isn't a candidate because *φ: V(G[q'] ) ↦ V(G[q])* can't be a bijection,
- The candidates for a query are exactly the semicandidates of length n.

It is now discussed an algorithm of the implementations that implements the step of determining the sub-graphs of the given B-rep graph which are isomorphic and topologically similar to the query B-rep graph. First it is provided an algorithm that finds the sub-graphs isomorphic to the query B-rep graph, and then a modified algorithm that implements the step of determining the sub-graphs of the given B-rep graph which are isomorphic and topologically similar to the query B-rep graph.

**Inputs**

G : the BRep graph of a CAD object
q : the query q ⊂ V(G)

**Initialization**

*semicandidates = [{Ø, Ø}] (the empty Semicandidate Graph) root ∈ q (randomly sampled)*

### Algorithm

**For Each** $nonexplored\ Face\ f \in q, exploring\ G[q]\ with\ BFS$

$(breadth\ first\ search)\ starting\ from\ root:$

$new\_semicandidates \leftarrow [\ ]$

**For Each** $(path, \varphi) \in semicandidates:$

**For Each** $f' \in V(G)|f' \notin V(path):$

$$\varphi' \leftarrow \left(x \mapsto \begin{cases} f\ if\ x = f' \\ \varphi(x)\ else \end{cases}\right)$$

**If** $(G[V(path) \cup \{f'\}], \varphi')\ is\ a\ semicandidate\ graph:$

$new\_semicandidates \leftarrow new\_semicandidates\ +$

$(G[V(path) \cup \{f'\}], \varphi')$

$semicandidates \leftarrow new\_semicandidates$

### Output

$A\ list\ of\ all\ candidate\ graphs$

This algorithm gives all the candidates graphs that are isomorphic to the query.

### Proof

Completeness

The algorithm ends because each loop is looping on a finite set.

Success

Let $G[q]$ where $q = (f_1, f_2, \dots) \in V(G)^n$, the query
Let
$H_i$: "At loop turn $i$, semicandidates contains exactly all the semicandidates of G, $(G', \varphi)$ such that $G' \cong G[f_1, \dots, f_i]$" be the

loop invariant We'll prove that $H_i$ is true $\forall i \in [\![0, n]\!]$. **_i=0_**
semicandidates contains one empty semicandidate $(\emptyset, \emptyset)$
The empty semicandidate is the only semicandidate of length $0$
So, $H_0$ is True

**_Let_** $i \in [\![0, n-1]\!]$, **_let suppose $H_i$ True_**
**_We'll prove $H_{i+1}$_**
Let's call $f_j$ the face from q treated during the $j^{th}$ loop
Let's $q_i = \{f_1, \dots, f_i\} \in V(G)^i$ and $q_{i+1} = \{f_1, \dots, f_{i+1}\} \in V(G)^{i+1}$. $q_{i+1} = q_i \cup \{\varphi^{-1}(f_{i+1})\} \ \forall \ (G', \varphi) \in semicandidates$

- After one loop, new_semicandidates contains only semicandidates$(G', \varphi)$such that $G' \cong G[q_{i+1}]$ by construction.
- Let $(P, \varphi)$, a semicandidate of length $i + 1$. $P \cong G[q_{i+1}]$.

- $$\exists\, q'_{i+1} \in V[G]^{i+1} | P = G[q'_{i+1}] \cong G[q_{i+1}].$$

* $\varphi: q'_{i+1} \mapsto q_{i+1}$ _is the associated bijection_ $| \; \forall \; e(f, \; g) \in \; G, \; e(f, \; g) \in$

$$E(G[q'_{i+1}]) \Leftrightarrow e(\varphi(f), \varphi(g)) \in E(G[q_{i+1}])$$

- _Let_ $q'_i = q'_{i+1} - \{\varphi^{-1}(f_{i+1})\}$

$\Rightarrow \quad \varphi|_{q'_i}: q'_i \mapsto q_i$ _stays bijective and_ $\{f, g\} \in G[q'_i] \Leftrightarrow e(\varphi|_{q'_i}(f), \varphi|_{q'_i}(g))$

$\in G[q_i]. (q_i \subset q_{i+1} \; and \; q'_i \subset q'_{i+1})$

$\Rightarrow \quad G[q'_i] \cong G[q_i]$

$$(G[q'_i], \varphi|_{q'_i})$$

$\Rightarrow$ _By hypothesis_ _is in candidates at loop i._
_During loop i + 1._

_The algorithm treats_ $(G[q'_i], \varphi|_{q'_i})$ _and the face_ $\varphi^{-1}(f_{i+1})$: _it detects that_

$$G[q'_{i+1}] = G[q'_i \cup \{\varphi^{-1}(f_{i+1})\}] \cong G[q_{i+1}].$$

_So_ $(G[q'_{i+1}] = P, \varphi)$ _, is added to new_semicandidates_
_So new_semicandidates contains all the semicandidates isomorphic to G'_
_So semicandidates contains all the semicandidates isomorphic to G' at the end of loop_
**_So $H_{i+1}$ is True_**

**_By recurrence $H_i$ is true_** $\forall i \in [\![0, n]\!]$
_So $H_n$ is true. At the end of the algorithm, semicandidates contains all_
_the semicandidates $(P, \varphi)$ with $P \cong G[q_n]$_
$\cong G[q]$. _Due to the Theorem 1. We obtain_
_all the candidates $(P, \varphi)$ to the query_

### _Remarks:_

- It is totally possible that a same graph has several bijections possible.

In that case they will all be computed

Once all the candidates are obtained, the method may comprise filtering them to extract the most similar ones. To do so, the following scores are used.

### Scoring

_Let $(G[q'], \varphi)$ a candidate graph of G[q]._

Let $\psi$: $G \mapsto \mathbb{R}^d$ *the function which map each Face of G to*

*his similarity signature. Let Sim:* $(\mathbb{R}^d)^2 \mapsto [0,1]$ *the simularity function*
*We define two scores :*

$$S_1\big((G[q'], \varphi)\big) = \frac{1}{|q'|} \sum_{f \in q'} Sim\left(\psi\big(\varphi(f)\big), \psi(f)\right)$$

$$S_\infty\big((G[q'], \varphi)\big) = \min_{f \in q'} Sim(\psi\big(\varphi(f)\big), \psi(f))$$

The method may apply a filter to the results, with the condition:

$$S_\infty\big((G[q'], \varphi)\big) \geq threshold$$

To do so, implementations include this filter to the construction algorithm, which is edited as follows (this edition being the algorithm that carries out the determination of the sub-graphs isomorphic and topologically similar to the query B-rep graph)

## Inputs

*G : the BRep graph of a CAD object*
*q : the query $q \subset V(G)$*
*threshold : the minimum similarity score allowed*

## Initialization

*semicandidates = [{Ø, Ø}] (the empty Semicandidate Graph) root $\in q$ (randomly sampled)*

## Algorithm

**For Each** $nonexplored\ Face\ f \in q, exploring\ G[q]\ with\ BFS$

$(breadth\ first\ search)\ starting\ from\ root$:

$new\_semicandidates \leftarrow [\ ]$

**For Each** $(path, \varphi) \in semicandidates$:

**For Each** $f' \in V(G)|f' \notin V(path)$:

$$\varphi' \leftarrow \left(x \mapsto \begin{cases} f\ if\ x = f' \\ \varphi(x)\ else \end{cases}\right)$$

**If** $(G[V(path) \cup \{f'\}], \varphi')\ is\ a\ semicandidate\ graph$:

**If** $Sim(\psi(f), \psi(f')) \geq threshold$:

$new\_semicandidates \leftarrow$

$new\_semicandidates +$

$(G[V(path) \cup \{f'\}], \varphi')$

$semicandidates \leftarrow new\_semicandidates$

## Output

$A\ list\ of\ all\ candidate\ graphs,$

$\forall\ (G[q'], \varphi) \in semicandidates,\ S_\infty((G[q'], \varphi)) \geq threshold.$

## Remarks

- The proof for containing candidates remain the same;
- To prove that this condition is equivalent to filtering by $S_\infty$ score, one has to notice that if a candidate $(P, \varphi)$ is not present in the second algorithm, that is equivalent to: it exists a face $f$ such that $Sim(f', \varphi(f')) < threshold$ and thus

$$S_\infty((G[q'], \varphi)) = \min_{f \in q'} Sim(\psi(\varphi(f)), \psi(f)) \leq Sim(f', \varphi(f')) <$$
$$threshold;$$

- This modification significantly accelerates the computing time with a choice of threshold higher than 0.5.

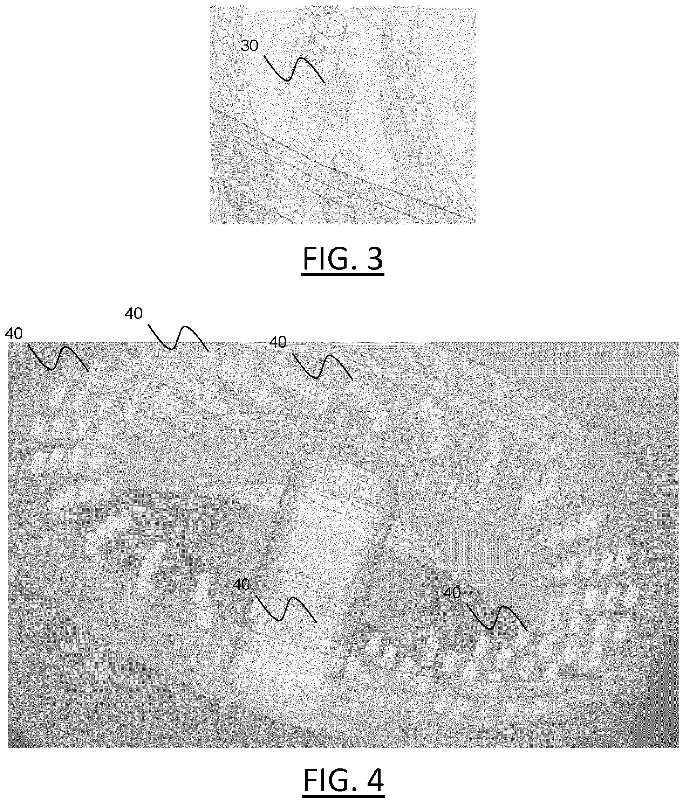

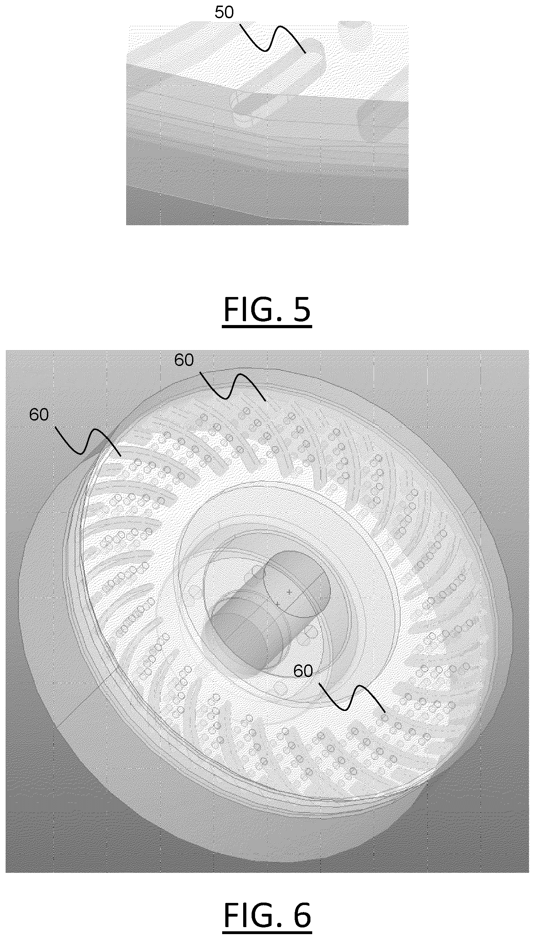

The method may comprise ranking the obtained candidates, for example with the $S_1$ score to get the most similar.
Examples of results obtained by the method are now discussed.
In the first example, the user selects a cylinder with 2 faces in a B-rep model of a wheel. FIG. 3 shows an example of the B-rep with the 2 faces cylinder 30 being selected. The query B-rep graph is thus the sub-graph of the graph of the wheel B-rep that corresponds to these two faces. FIG. 4 shows all the 2 faces cylinders (some being illustrated by reference 40) of the B-rep of which B-rep graphs have been identified as sub-graphs of the wheel B-rep graph isomorphic and topologically similar to the query B-rep graph of the input cylinder 30. On FIG. 4, only the cylinder of which sub-graphs have a similarity score $S_\infty \geq 0.995$ are displayed.
In the second example, a 4 faces vein 50 has been selected by the user, still on the same wheel B-rep, as illustrated on FIG. 5. The query B-rep graph is thus the sub-graph of the wheel B-rep graph that corresponds to these 4 faces. FIG. 6. shows all the 4 faces veins (some being illustrated by reference 60) of the B-rep of which B-rep graphs have been identified as sub-graphs of the wheel B-rep graph isomorphic and topologically similar to the query B-rep graph of the input vein 50. Small veins and large veins are identified, as illustrated on FIG. 6. The table below shows the $S_\infty$ and $S_1$ scores to the query for these different veins.

| | $S_1$ | $S_\infty$ |
|---|---|---|
| (Query) | 1 | 1 |
| Small Veins | 0,999 | 0,999 |
| Large Veins | 0,97 | 0,95 |

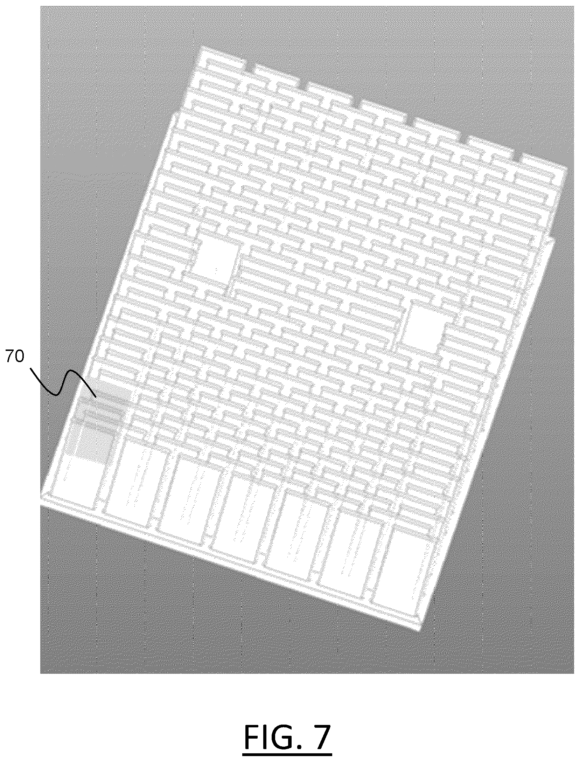

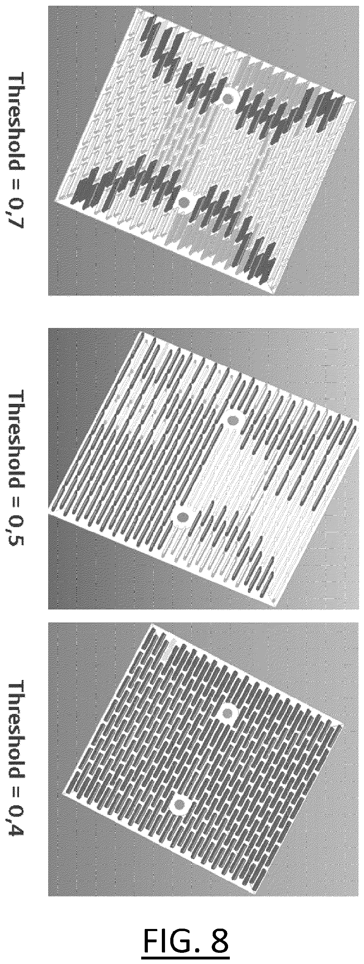

In the third example, the faces of a fin in a heat B-rep model have been selected by the user, as illustrated on FIG. 7 (the fin being shown by reference 70). FIG. 8 shows the results depending on the similarity score threshold selected in the algorithm (filtering step of the method)

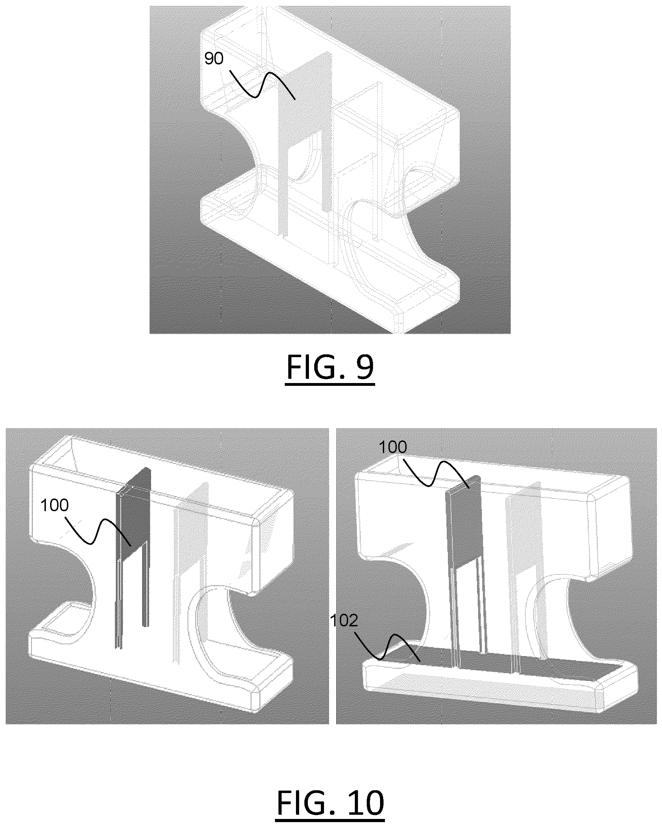

In the fourth example, the faces of the B-rep sub-part 90 have been selected, as shown on FIG. 9. As shown on FIG. 10, sub-part 100 is identified by the method, with a similarity score $S_\infty$ of 0.924 and a similarity score $S_1$ of 0.971. Sub-part 102 has a similarity score $S_\infty$ of 0.528 and a similarity score $S_1$ of 0.883 and may thus not be identified by the method as it has a too small similarity score.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

FIG. 11 shows an example of the system, wherein the system is a client computer system, *e.g.* a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1.  A computer-implemented method for local topological similarity retrieval in a B-rep model represented by a given B-rep graph, each node of the given B-rep graph representing a B-rep element and being associated with a topological signature of the element, the method comprising:

    - providing a query B-rep graph, each node of the query B-rep graph representing a B-rep element and being associated with a topological signature of the element; and
    - determining one or more sub-graphs of the given B-rep graph, each determined sub-graph being isomorphic to the query B-rep graph, the determining of the one or more sub-graphs comprising:

        ◦ searching for sub-graphs isomorphic to the query B-rep graph; and
        ◦ filtering the sub-graphs isomorphic to the query B-rep graph based on topological signature proximity with the query B-rep graph.

2.  The method of claim 1, wherein the determining of the one or more sub-graphs comprises iterations of:

    - given a sub-graph of the query B-rep graph, the sub-graph resulting from the previous iteration, adding a node of the query B-rep graph to the sub-graph; and
    - determining all sub-graphs of the given B-rep graph already determined as isomorphic and similar according to topological signature proximity to the sub-graph of the query B-rep graph resulting from the previous iteration and remaining isomorphic to the sub-graph of the query B-rep graph when adding a node corresponding to the node added to the sub-graph of the query B-rep graph, and such that the determined sub-graphs remain similar to the sub-graph of the query graph according to topological signature proximity when adding the node.

3.  The method of claim 2, wherein the determining of said all sub-graphs comprises, for sub-graphs determined as remaining isomorphic to the sub-graph of the query B-rep graph when adding the node, selecting the sub-graphs for which the added node and the corresponding node added to the query have topological signature proximity.

4.  The method of claim 3, wherein two nodes have topological signature proximity when a similarity score between their two topological signatures is larger than a predefined threshold.

5.  The method of claim 4, wherein the topological signatures are vectors, and the similarity score is a similarity score between vectors.

6.  The method of claim 5, wherein the similarity score is a cosine similarity.

7.  The method of any one of claims 1 to 6, wherein the method further comprises, for each sub-graph of the one or more sub-graphs resulting from the determining:

    - computing a graph similarity score quantifying a similarity between the sub-graph and the query B-rep graph based on the topological signatures of their elements.

8.  The method of claim 7, wherein the method further comprises:

    - ranking the one or more sub-graphs according to their computed graph similarity score;
    - clustering the one or more sub-graphs according to their computed graph similarity score;
    - discarding one or more sub-graphs for which the graph similarity score is smaller than a predefined threshold; and/or
    - selecting one or more sub-graphs for which the graph similarity score is larger than a predefined threshold.

9.  The method of claim 7 or 8, wherein the graph similarity score between two B-rep graphs is:

- a mean of the vector similarities each between the topological signatures of two corresponding nodes in the two graphs; or
- a minimal vector similarity among the vector similarities each between the topological signatures of two corresponding nodes in the two graphs.

10. A computer program comprising instructions which, when executed by a computer system, cause the computer to perform the method of any one of claims 1 to 9.

11. A computer-readable data storage medium having recorded thereon the computer program of claim 10.

12. A computer comprising a processor coupled to a memory, the memory having recorded thereon the computer program of claim 10.

# Inputs

Full 3D model                    Query

# FIG. 1

# Outputs

Query          Isomorphic →          Candidates

Extracted from

# FIG. 2

FIG. 3

FIG. 4

## FIG. 5

## FIG. 6

70

FIG. 7

Threshold = 0,7

Threshold = 0,5

Threshold = 0,4

FIG. 8

FIG. 9

FIG. 10

# FIG. 11

# EP 4 636 610 A1

## EUROPEAN SEARCH REPORT

**Application Number**

EP 24 30 5601

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/239694 A1 (SINGH AMBUJ K [US] ET AL) 11 October 2007 (2007-10-11) * paragraphs [0035], [0037], [0038], [0040], [0041] * | 1-12 | INV. G06F16/901 G06F17/10 |
| A | DEMIRCI M F ET AL: "Indexing through laplacian spectra", COMPUTER VISION AND IMAGE UNDERSTANDING, ACADEMIC PRESS, US, vol. 110, no. 3, 1 June 2008 (2008-06-01), pages 312-325, XP022652942, ISSN: 1077-3142, DOI: 10.1016/J.CVIU.2007.09.012 [retrieved on 2007-12-15] * the whole document * | 1-12 | |
| A | US 2024/061980 A1 (MEZGHANNI MARIEM [FR] ET AL) 22 February 2024 (2024-02-22) * the whole document * | 1-12 | |

**TECHNICAL FIELDS SEARCHED (IPC)**

G06F

The present search report has been drawn up for all claims

| Place of search | Date of completion of the search | Examiner |
|---|---|---|
| Berlin | 5 August 2024 | Haffner, Ronald |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 636 610 A1**

## ANNEX TO THE EUROPEAN SEARCH REPORT
## ON EUROPEAN PATENT APPLICATION NO.

EP 24 30 5601

05-08-2024

| Patent document cited in search report | Publication date | Patent family member(s) | | Publication date |
|---|---|---|---|---|
| US 2007239694 A1 | 11-10-2007 | US | 2007239694 A1 | 11-10-2007 |
| | | WO | 2007100834 A2 | 07-09-2007 |
| US 2024061980 A1 | 22-02-2024 | CN | 117592576 A | 23-02-2024 |
| | | EP | 4325388 A1 | 21-02-2024 |
| | | EP | 4339826 A2 | 20-03-2024 |
| | | JP | 2024028206 A | 01-03-2024 |
| | | US | 2024061980 A1 | 22-02-2024 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 23306709